# EUROPÄISCHE PATENTSCHRIFT

(11) **EP 1 186 030 B1**
(45) Veröffentlichungstag und Bekanntmachung des Hinweises auf die Patenterteilung: **04.05.2011**
(21) Anmeldenummer: 00943545.4
(22) Anmeldetag: 04.05.2000
(51) Int. Cl.: H01L 21/8242, H01L 21/02

(54) **KONDENSATOR FÜR HALBLEITERANORDNUNG UND VERFAHREN ZUM HERSTELLEN EINER DIELEKTRISCHEN SCHICHT FÜR DENSELBEN**
CAPACITOR FOR A SEMICONDUCTOR ARRANGEMENT AND METHOD FOR PRODUCING A DIELECTRIC LAYER FOR THE CAPACITOR
CONDENSATEUR POUR DISPOSITIF SEMI-CONDUCTEUR ET PROCEDE D'OBTENTION D'UNE COUCHE DIELECTRIQUE POUR CE CONDENSATEUR

(30) Priorität: 12.05.1999 DE 19922180
(43) Veröffentlichungstag der Anmeldung: 13.03.2002
(73) Patentinhaber: Qimonda AG, 81739 München (DE)
(72) Erfinder: HANEDER, Thomas, Peter, D-81549 München (DE); REISINGER, Hans, D-82031 Grünwald (DE); STENGL, Reinhard, D-86391 Stadtbergen (DE); BACHHOFER, Harald, D-81677 München (DE); HÖNLEIN, Wolfgang, D-82008 Unterhaching (DE)
(74) Vertreter: Kottmann, Heinz Dieter
(86) Internationale Anmeldenummer: PCT/DE2000/001405
(87) Internationale Veröffentlichungsnummer: WO 2000/070674

(56) Entgegenhaltungen:
- US-A- 4 891 684
- US-A- 5 195 018
- US-A- 5 792 592
- US-A- 5 801 105
- US-A- 5 834 804
- US-A- 5 895 946
- PATENT ABSTRACTS OF JAPAN vol. 1998, no. 09, 31. Juli 1998 (1998-07-31) & JP 10 107216 A (NISSAN MOTOR CO LTD), 24. April 1998 (1998-04-24)
- PATENT ABSTRACTS OF JAPAN vol. 1998, no. 14, 31. Dezember 1998 (1998-12-31) & JP 10 247722 A (INTERNATL BUSINESS MACH CORP <IBM>), 14. September 1998 (1998-09-14) & US 5 973 351 A (IBM) 26. Oktober 1999 (1999-10-26)

## Beschreibung

Die vorliegende Erfindung betrifft einen Kondensator für eine Halbleiteranordnung, mit einer zwischen zwei Elektroden vorgesehenen dielektrischen Schicht, die aus Ceroxid (CeO₂) oder Hafniumoxid (HfO₂) besteht, sowie ein Verfahren zum Herstellen dieser dielektrischen Schicht.

DRAMs (dynamische Schreib/Lesespeicher) in Silizium-Prczeßtechnologie verwenden derzeit vor allem Speicherkondensatoren, deren dielektrische Schicht aus Siliziumnitrid (Si₃N₄) und/oder Siliziumdioxid (SiO₂) besteht. Diese sogenannten NO-(Nitrid/Oxid-)Schichten sind weit und werden ganz allgemein als Dielektrika von Speicherkcndensatoren eingesetzt.

Ein gewisser Nachteil von NO-Schichten als Dielektrika ist deren begrenzte Skalierbarkeit. Daher besteht schon seit geraumer Zeit ein Bedarf für andere Materialien für die dielekschichten von Kondensatoren, um mit diesen anderen Materialien höhere spezifische Kapazitäten, also Kapazitätswerte/Flächeneinheit, zu erreichen. Solche Materialien sind beispielsweise Tantalpentoxid (Ta₂O₃) und Titandioxid (TiO₂), die sich durch hohe Dielektrizitätskonstanten auszeichnen. Infolge dieser hohen Dielektrizitätskonstanten ist es möglich, mittels Tantalpentoxid und Titandioxid kleinere NO-äquivalente Dicken und damit höhere spezifische Kapazitäten zu erreichen.

Speziell bei der DRAM-Herstellung besteht ein Bedarf für eine dielektrische Schicht, die einerseits die Erzielung einer gegenüber NO erheblich höheren spezifischen Kapazität erlaubt und die andererseits ohne weiteres mit der Silizium-Prozeßtechnologie, die bei der DRAM-Herstellung zur Anwendung gelangt, integriert werden kann. Solche Materialien für dieiektrische Schichten sollen sich zudem durch eine geringe Defektdichte, eine hohe Durchbruchsfeldstärke (in der Größenordnung bis zu 10 MV/cm und höher), geringere Leckströme und große relative Dielektrizitätskonstanten über 20 auszeichnen und dabei geringe NO-äquivalente Dicken haben.

Aus der JP 10-107216 A ist ein Kondensator bekannt, dessen Dielektrikum aus mit Yttrium stabilisiertem Zirkoniumoxid besteht.

Es ist Aufgabe der vorliegenden Erfindung, einen Kondensator für eine Halbleiteranordnung zu schaffen, dessen dielektrische Schicht die Erzielung hoher spezifischer Kapazitäten ermöglicht und mit der Silizium-Prozeßtechnologie integrierbar ist; außerdem soll ein Verfahren zum Herstellen einer dielektrischen Schicht für einen solchen Kondensator angegeben werden.

Diese Aufgabe wird bei einem Kondensator für eine Halbleiteranordnung, mit einer zwischen zwei Elektroden vorgesehenen dielektrischen Schicht, die aus Ceroxid (CeO₂) oder Hafniumoxid (HfO₂) besteht, erfindungsgemäß dadurch gelöst, dass das Ceroxid oder Hafniumoxid durch einen geringen Zusatz an Yttrium stabilisiert ist.

Ein Verfahren zum Herstellen einer solchen dielektrischen Schicht zeichnet sich dadurch aus, daß die dielektrische Schicht durch Sputtern aus einem Target, durch einen CVD-Prozeß mit Precursoren oder Spin-On (Auftragen durch Schleudern) erzeugt ist. Als Precursoren werden insbesondere Ce(thd)₄ oder Ceriumdimethoxyethoxide in methoxyethanol (Ce(OCH₂CH₂OCH₃)₃) verwendet.

Die dielektrische Schicht kann gegebenenfals auch aus mehreren Filmen aufgebaut sein, die jeweils aus Ceroxid oder Hafniumoxid bestehen. Auch ist es möglich, für einen dieser Filme Siliziumnitrid vorzusehen. Eine bevorzugte Filmdicke für einen solchen Siliziumnitridfilm der dielektrischen Schicht beträgt etwa 1 bis 3 nm.

Das Ceroxid und Hafniumoxid der dielektrischen Schicht ist durch Yttrium stabilisiert. Es genügt dabei bereits ein geringer Zusatz an Yttrium. Zur Verringerung von Bulk-Defekten und zur Verbesserung der Grenzfläche - wenn Silizium als Elektrodenmaterial verwendet wird - können die genannten Oxide außerdem beispielsweise mit Silizium oder Aluminium dotiert werden.

Die Elektroden des Kondensators können vorzugsweise aus Silizium, beispielsweise polykristallinem, dotiertem Silizium, bestehen. Dies ist möglich, da Ceroxid und Hafniumoxid eine große Bildungsenthalpie ausweisen. Die Verwendung von Silizium als Elektrodenmaterial ist besonders verteilhaft, wenn der Kondensator in einem DRAM eingesetzt wird und hierfür tiefe Gräben ("Deep Trenches") vorgesehen werden. Die dielektrische Schicht des Kondensators wird dabei auf Silizium im Graben aufgebracht.

Ceroxid und Hafniumoxid können durch Sputtern aus einem Target, mit einem CVD-Prozeß (CVD = chemische Abscheidung aus der Dampfphase) und entsprechenden Precursoren oder mit einem Spin-On-(bzw. Schleuder-)Verfahren aus einem speziellen Precursor für diese Art der Abscheidung hergestellt werden. Anschließende Temperungen hängen von der Art der Abscheidung, der Art des Materials, also Ceroxid
oder Hafniumoxid, der Schichtdicke und den gewünschten Eigenschaften ab. Jedoch finden die Temperungen vorzugsweise in einer Sauerstoffatmosphäre und bei Temperaturen von 500 bis 800°C statt.

Dielektrische Schichten aus Ceroxid oder Hafniumoxid können, wie Versuche gezeigt haben, problemlos mit der Silizium-Prozeßtechnologie, wie diese bei der DRAM-Herstellung zur Anwendung gelangt, integriert werden. Weitere Vorteile dieser dielektrischen Schichten aus Ceroxid
und Hafniumoxid liegen in einer relativ geringen Defektdichte, einer hohen Durchbruchsfeldstärke von 10 MV/cm
und darüber und einer großen relativen Dielektrizitätskonstanten εᵣ > 20. Da außerdem die NO-äquivalenten Dicken einer dielektrischen Schicht aus Ceroxid oder Hafniumoxid gering sind, sind diese Materialien besonders für DRAMs zukünftiger Generationen äußerst interessant.

Nachfolgend wird die Erfindung anhand eines in der Zeichnung dargestellten Ausführungsbeispiels näher erläutert, wobei in der einzigen Figur der Zeichnung ein Speicherkondensator zustammen mit einem Transistor eines DRAMs gezeigt ist.

In einem p-leitenden Halbleiterkörper 1 befindet sich ein Graben 2, der beispielsweise durch Ätzen in den Halbleiterkörner 1 eingebracht sein kann. Die Oberfläche dieses Grabens 2 ist mit einer dielektrischen Schicht 3 belegt, die aus Ceroxid oder Hafniumoxid besteht. Für die dielektrische Schicht 3 können auch einzelne Filme 31,32 aus diesen Materialien gewählt werden. So ist es beispielsweise möglich, für die dielektrische Schicht 3 einen Film 31 aus Ceroxid
vorzusehen. Die dielektrische Schicht 3 kann aber auch aus mehr als zwei Filmen bestehen (vgl. Einzelheit A).

Weiterhin ist es möglich, für einen dieser Filme einen Siliziumnitridfilm mit einer Schichtdicke von 1 bis 3 nm vorzusehen.

Der an den Graben 2 angrenzende Bereich des Halbleiterkörpers 1 besteht aus einer n⁺-leitenden Zone 4, während der Innenraum des Grabens 2 hinter der dielektrischen Schicht 3 mit dotiertem polykristallinem Silizium 5 gefüllt ist.

Das polykristalline Silizium 5 bildet eine Elektrode eines Kondensators, dessen andere Elektrode aus der hochdotierten Zone 4 besteht. Zwischen diesen beiden Elektroden liegt die dielektrische Schicht 3.

Außerdem sind in der Figur noch ein Transistor 6 mit einer Gateelektrode 7 aus n⁺-leitendem polykristallinem Silizium gezeigt, welche in eine Isolationsschicht 8 aus beispielsweise Siliziumdioxid und/oder Siliziumnitrid eingebettet ist. Eine Metallisierung 9 für den Transistor 6 bildet eine Bitleitung und besteht beispielsweise aus Wolfram oder Aluminium.

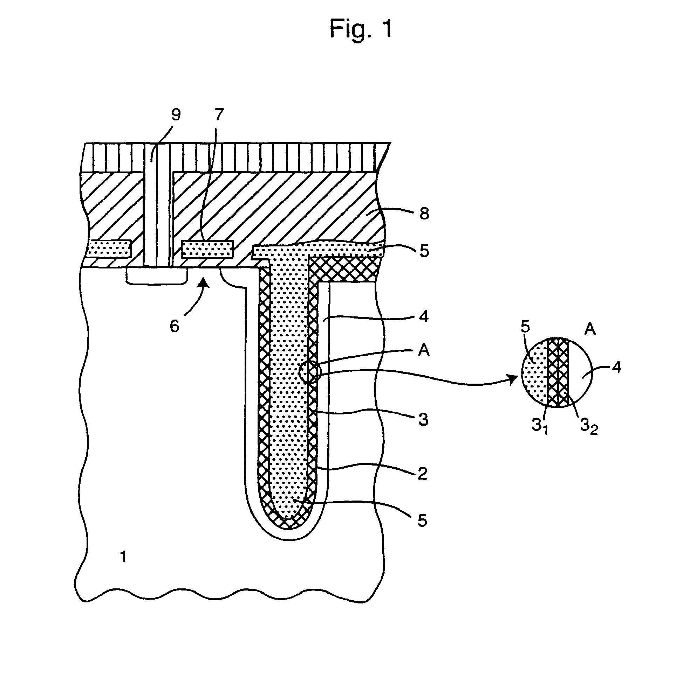

Ceroxid oder Hafniumoxid können problemlos mit der Silizium-Prozeßtechnologie integriert werden, wie diese zur Herstellung der in Fig. 1 gezeigten Halbleiteranordnung zur Anwendung gelangt. Diese Materialien zeichnen sich durch eine geringe Defektdichte, eine hohe Durchbruchsfeldstärke zu 10 MV/cm und durch eine große relative Dielektrizitätskonstante über 20 aus.

Das Ceroxid oder Hafniumoxid sind mit Yttrium stabilisiert wobei hierzu bereits ein geringer Zusatz ausreichend ist. Eine Dotierung mit beispielswei se Silizium oder Aluminium kann zur Reduzierung von Bulk-Defekten und zur Verbesserung der Grenzfläche zu den Silizium-Elektroden verwendet werden.

Diese dielektrischen Schichten aus Ceroxid oder Hafniumoxid können auch bei sogenannten Stapel-DRAM-Zellen eingesetzt werden, bei denen der Kondensator über dem Transistor liegt und bei denen die Elektroden aus hochdotiertem polykristallinem Silizium oder aus Metall, wie beispielsweise Platin oder Iridium, bestehen.

Bei der in Fig. 1 gezeigten Halbleiteranordnung kann das Ceroxid oder Hafniumoxid für die dielektrische Schicht 3 beispielsweise mittels eines CVD-Prozesses und den entsprechenden Precursoren aufgetragen werden, woran sich eine Temperung im Bereich von 500 bis 750°C in einer Sauerstoff-Atmosphäre anschließt. Die genauen Temperaturwerte hängen dabei von der Schichtdicke und den gewünschten Eigenschaften der dielektrischen Schicht 3 ab.

## Patentansprüche

1. Kondensator für Halbleiteranordnung mit einer zwischen zwei Elektroden (4, 5) vorgesehenen dielektrischen Schicht (3), die aus Ceroxid (CeO₂ oder Hafniumoxid (HfO₂) besteht, **dadurch gekennzeichnet, dass** das Ceroxid oder Hafniumoxid durch einen geringen Zusatz an Yttrium stabilisiert ist.

2. Kondensator nach Anspruch 1,
**dadurch gekennzeichnet, dass** die dielektrische Schicht (3) mehrere Filme (3₁, 31) aufweist, die aus Ceroxid oder Hafniumoxid bestehen.

3. Kondensator nach Anspruch 2,
**dadurch gekennzeichnet, dass** zusätzlich ein Film (3₁, 31) aus Siliziumnitrid und/oder Siliziumoxid vorhanden ist.

4. Kondensator nach Anspruch 3,
**dadurch gekennzeichnet, dass** der aus Siliziumnitrid bestehende Film eine Filmdicke von 1 bis 3 nm aufweist.

5. Kondensator nach einem der Ansprüche 1 bis 4, **dadurch gekennzeichnet, dass** die Elektroden (4, 5) aus Silizium bestehen.

6. Kondensator nach einem der Ansprüche 1 bis 5, **dadurch gekennzeichnet, dass** die Elektroden in einem Graben (2) gelegen sind.

7. Kondensator nach einem der Ansprüche 1 bis 6, **dadurch gekennzeichnet, dass** der Kondensator ein DRAM-Kondensator ist.

8. Kondensator nach einem der Ansprüche 1 bis 7, **dadurch gekennzeichnet, dass** die dielektrische Schicht (3) zusätzlich mit Silizium oder Alumnium dotiert ist.

9. Verfahren zum Herstellen einer dielektrischen Schicht (3) für den Kondensator nach einem der Ansprüche 1 bis 8, **dadurch gekennzeichnet, dass** die dielektrische Schicht (3) durch Sputtern aus einem Target, einen CVD-Prozess mit Precursoren oder Spin-On erzeugt wird.

10. Verfahren nach Anspruch 9,
**dadurch gekennzeichnet, dass** die dielektrische Schicht getempert wird.

11. Verfahren nach Anspruch 10,
**dadurch gekennzeichnet, dass** die Temperung der dielektrischen Schicht in einer Sauerstoffatmosphäre bei 500 bis 800 °C durchgeführt wird.

## Claims

1. Capacitor for a semiconductor arrangement including a dielectric layer (3) arranged between two electrodes (4, 5), the dielectric layer being made of cerium oxide(CeO₂) or hafnium oxide (HfO₂), **characterized in that** the cerium oxide or hafnium oxide is stabilized by a slight addition of yttrium.

2. The capacitor of claim 1, **characterized in that** the dielectric layer (3) comprises a plurality of films (3₁, 31), which are made of cerium oxide or hafnium oxide.

3. The capacitor of claim 2 **characterized by**, in addition, including one film (3₁, 31) of silicon nitride and/or silicon oxide.

4. The capacitor of claim 3, **characterized in that** the film made of silicon nitride has a thickness in a range of 1 to 3 nm.

5. The capacitor according to any of claims 1 to 4, **characterized in that** the electrodes (4, 5) are made of silicon.

6. The capacitor according to any of claims 1 to 5, **characterized in that** the electrodes are arranged in a trench (2).

7. The capacitor according to any of claims 1 to 6, **characterized in that** the capacitor is a DRAM capacitor.

8. The capacitor according to any of claims 1 to 7, **characterized in that** the dielectric layer (3) is additionally doped with silicon or aluminum.

9. Method for manufacturing a dielectric layer (3) for the capacitor according to any of claims 1 to 8, **characterized in that** the dielectric layer (3) is manufactured by sputtering from a target, a CVD process including precursors or by spin-on.

10. The method according to claim 9, **characterized in that** the dielectric layer is being annealed.

11. The method according to claim 10, **characterized in that** annealing of the dielectric layer is carried out in an oxygen ambient at 500 to 800°C.

## Revendications

1. Condensateur pour dispositif à semi-conducteur comprenant une couche (3) diélectrique prévue entre deux électrodes (4, 5) et constituée d'oxyde de cérium (CO₂) ou d'oxyde d'hafnium (HfO₂), **caractérisé en ce que** l'oxyde de cérium ou l'oxyde d'hafnium est stabilisé par une petite addition d'yttrium.

2. Condensateur suivant la revendication 1,
**caractérisé en ce que** la couche (3) diélectrique a plusieurs films (3₁, 31) qui sont en oxyde de cérium ou en oxyde d'hafnium.

3. Condensateur suivant la revendication 2,
**caractérisé en ce qu'**il y a supplémentairement un film (3₁, 31) en nitrure de silicium et/ou en oxyde de silicium.

4. Condensateur suivant la revendication 3,
**caractérisé en ce que** film en nitrure de silicium a une épaisseur de 1 à 3 nm.

5. Condensateur suivant l'une des revendications 1 à 4, **caractérisé en ce que** les électrodes (4, 5) sont en silicium.

6. Condensateur suivant l'une des revendications 1 à 5, **Caractérisé en ce que** les électrodes sont mises dans un sillon (2).

7. Condensateur suivant l'une des revendications 1 à 6, **caractérisé en ce que** le condensateur est un condensateur DRAM.

8. Condensateur suivant l'une des revendications 1 à 7, **caractérisé en ce que** la couche (3) diélectrique est dopée supplémentairement par du silicium ou par de l'aluminium.

9. Procédé de production d'une couche (3) diélectrique pour le condensateur suivant l'une des revendications 1 à 8, **caractérisé en ce que** l'on produit la couche (3) diélectrique par pulvérisation cathodique à partir d'une cible par un procédé CVD avec des précurseurs ou par spin-on.

10. Procédé suivant la revendication 9,
**caractérisé en ce que** l'on recuit la couche diélectrique.

11. Procédé suivant la revendication 9,
**caractérisé en ce que** l'on effectue le recuit de la couche d iélectrique dans une atmosphère d'oxygène entre 500 et 800°C.
